(19) Europäisches Patentamt

European Patent Office

Office européen des brevets

(11) Veröffentlichungsnummer: **0 103 889**

A2

## (12) EUROPÄISCHE PATENTANMELDUNG

(21) Anmeldenummer: 83109338.0

(22) Anmeldetag: 20.09.83

(51) Int. Cl.³: **H 01 L 21/60**
**H 01 L 21/68**

(30) Priorität: 20.09.82 DE 3234744

(43) Veröffentlichungstag der Anmeldung:
28.03.84 Patentblatt 84/13

(84) Benannte Vertragsstaaten:
AT DE FR GB IT

(71) Anmelder: SIEMENS AKTIENGESELLSCHAFT
Berlin und München Wittelsbacherplatz 2
D-8000 München 2(DE)

(72) Erfinder: Fritz, Otmar, Dipl.-Ing.
Johann-Hackl-Ring 64
D-8011 Neukeferloh(DE)

(54) Verfahren und Vorrichtung zum Verarbeiten von einzelnen integrierten Schaltkreisen zu filmmontierten integrierten Schaltkreisen (Mikropacks).

(57) Zum Verarbeiten von einzelnen integrierten Schaltkreisen zu filmmontierten integrierten Schaltkreisen (Mikropacks) wird auf einer sehr gut planparrallelen Trägerplatte aus schlecht wärmeleitenden Material eine Platte mit matrixförmig angeordneten Ausnehmungen in Größe der Einzelchips befestigt, die Einzelchips in die Ausnehmung dieser Platte eingelegt und die Gesamtanordnung in einem Kontaktierautomaten in an sich bekannter Weise weiterverarbeitet.

FIG 2

0103889

SIEMENS AKTIENGESELLSCHAFT    Unser Zeichen
Berlin und München           82 P 1 7 9 1 E

Verfahren und Vorrichtung zum Verarbeiten von einzelnen
integrierten Schaltkreisen zu filmmontierten integrierten
Schaltkreisen (Mikropacks).

Bei dem üblichen Verfahren zur Montage  von mit Anschlußhöckern versehenen integrierten Schaltkreisen zu filmmontierten integrierten Schaltkreisen (Mikropacks) wird
eine unzerteilte, die integrierten Schaltkreise enthaltende Scheibe auf einer Trägerplatte aufgewachst und in
einzelne Chips zersägt. Der Träger mit den nun vereinzelten
Chips, die durch die Wachsschicht in ihrer ursprünglichen,
durch die Scheibe vorgegebenen Position exakt festgehalten sind, wird auf dem X, Y-Verfahrtisch an dem Kontaktierautomaten (Inner-Lead-Bonder) gelegt und die guten Chips
werden direkt von dem Träger herunter weiterverarbeitet,
d.h. mit den Anschlußbeinchen der sogenannten Filmspinnen
kontaktiert.

Bei diesem bekannten Verfahren haben sich, insbesondere
bei vielpoligen, großflächigen Chips Probleme gezeigt. So
besteht z.B. infolge des geringen Abstandes der Anschlußhöckerreihen von in der Scheibe benachbarten Chips die
Gefahr, daß die Anschlußbeinchen einer Filmspinne beim Kontaktieren mit den Anschlußhöckern eines benachbarten Chips
in Kontakt kommen und dort ebenfalls angelötet werden.
Außerdem läßt es sich nicht mit allen Herstellern solcher
Schaltkreise vereinbaren,  daß die Schaltkreise in Form
kompletter Scheiben angeliefert werden, da unterteilt gelieferte Scheiben dem Anwender Aufschluß über die Ausbeute
an guten Chips geben würden.

Kar 1 Pe /16.9.82

Der vorliegenden Erfindung lag daher die Aufgabe zugrunde,
ein Verfahren und eine  Vorrichtung zu schaffen, mit denen
auch einzelne integrierte Schaltkreise (Chips) in normalerweise für Scheibenbearbeitung vorgesehenen Kontaktierungsautomaten zu Mikropacks weiterverarbeitet werden können.

Erfindungsgemäß wird dies dadurch erreicht, daß auf einer
sehr gut planparallelen Trägerplatte aus schlecht wärmeleitendem Material eine Platte mit matrixförmigen Ausnehmungen
in Größe der Einzelchips befestigt wird, daß die Einzelchips in die Ausnehmungen dieser Platte eingelegt werden
und anschließend die Gesamtanordnung in einen Kontaktierungsautomaten eingelegt und dort in an sich bekannter Weise
weiterbearbeitet wird.

Der Vorteil dieser erfindungsgemäßen Maßnahme ist, daß auf
diese Weise auch einzelne Chips wie die bekannten Trägerplatten mit aufgewachsten Chips in einem üblichen Kontaktierautomaten zur Herstellung der inneren Kontaktierung
von Mikropacks bearbeitet werden können.

Weitere Einzelheiten der Erfindung ergeben sich aus den
Unteransprüchen sowie aus der Beschreibung eines vorteilhaften Ausführungsbeispiels anhand der Figuren, wobei

Fig.1 einen Schnitt durch die erfindungsgemäße Vorrichtung,

Fig.2 symbolisch den Vorgang der inneren Kontaktierung,

Fig.3 die Anordnung und Ausgestaltung der Ausnehmungen in
      der sogenannten Matrixplatte und

Fig.4 die Lage eines Chips in einer Ausnehmung der Matrixplatte zeigen.

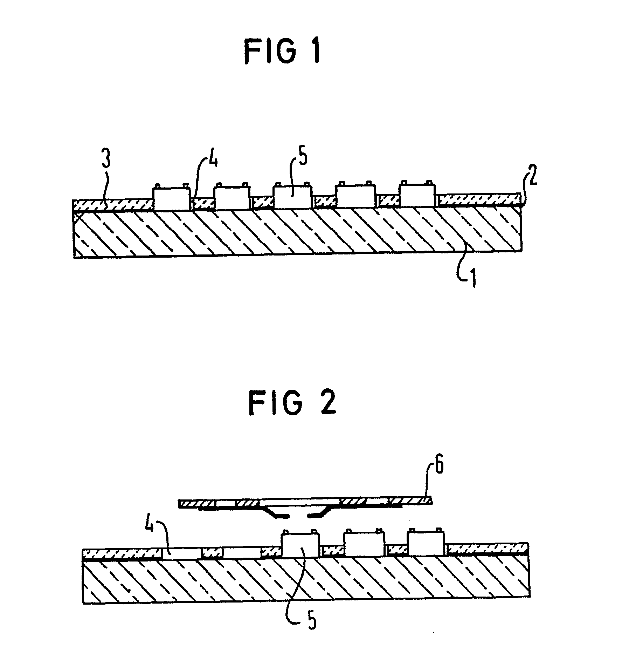

Fig.1 zeigt einen Schnitt durch eine erfindungsgemäße Vorrichtung, wobei insbesondere eine Trägerplatte 1 hoher Planparallelität, eine Platte 3 mit matrixförmig angeordneten Ausnehmungen 4 und die Anordnung von Einzelchips
in den Ausnehmungen der Platte 3 zu erkennen sind. Die
Trägerplatte 1 besteht aus schlecht wärmeleitendem Material,
vorzugsweise aus Glas. Die Matrixplatte 3 sollte aus nichtlötfähigem bzw. lötunfähig gemachten Material mit etwa
gleichem Ausdehnungskoeffizienten wie die Trägerplatte 1
bestehen. Sie ist z.B. mit Hilfe von Epoxidkleber 2 oder
mit Wafer-Wachs auf die Trägerplatte 1 aufgeklebt. Matrixplatten 3 aus Kovar oder aus Keramik haben sich als besonders
vorteilhaft erwiesen.

Die Dicke der Matrixplatte 3 einschließlich der Kleberschicht
2 sollte vorteilhafterweise kleiner sein als die minimale Dicke der zu kontaktierenden Einzelchips 5. Außerdem
sollte der gegenseitige Abstand der Ausnehmungen 4 in
der Matrixplatte 3 so groß sein, daß eine unbeabsichtigte
Kontaktierung benachbarter Chips 5 mit Sicherheit vermieden wird.

Figur 2 zeigt schematisch die gegenseitige Lage der Trägerplatte 1 mit Matrixplatte 3 und eines Filmträgers 6 mit
den Anschlußbeinchen für die innere Kontaktierung der Chips
5.

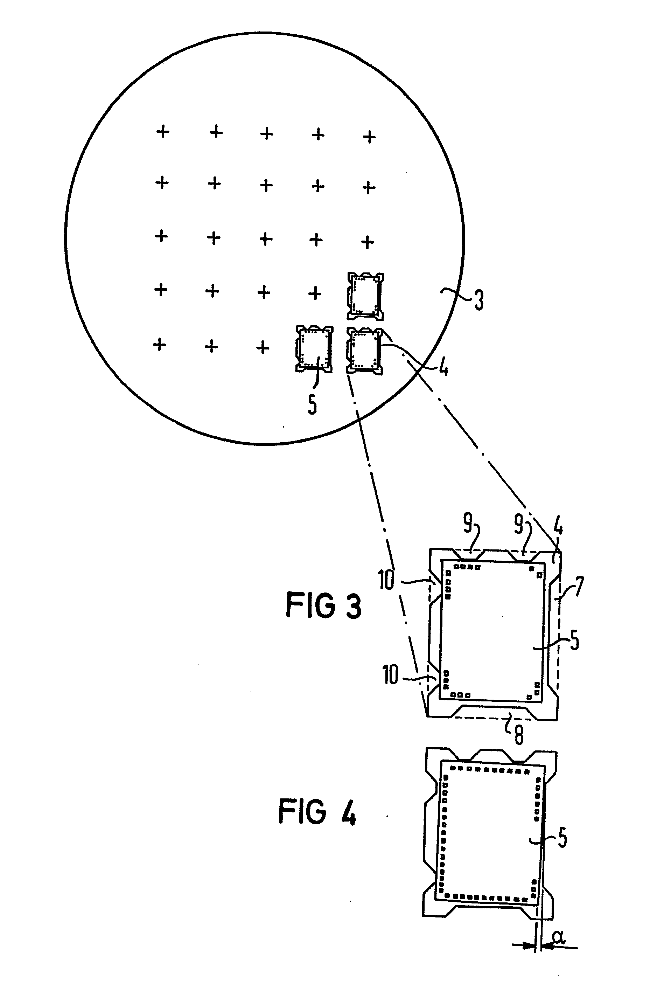

Figur 3 zeigt links oben die Draufsicht auf eine erfindungsgemäße Vorrichtung und insbesondere die Platte 3 mit den
matrixförmig angeordneten Ausnehmungen 4 in Größe der Einzelchips. Ferner ist in Figur 3 rechts unten zu erkennen,
daß die Ausnehmungen 4 im wesentlichen rechteckförmig
sind mit von den Rändern her nach innen ragenden trapezförmigen Ansätzen 7, 8,9 und 10. Als vorteilhaft hat es
sich erwiesen, an einer der Längsseiten und an einer der

0103889

82 P 1791 E

benachbarten Querseiten der Ausnehmungen 4 nur je einen
Ansatz 7 bzw. 8 und an den beiden anderen Seiten der Ausnehmungen je zwei Ansätze 9 bzw. 10 vorzusehen. Die Abmessungen der Ausnehmungen 4 sollten so gewählt sein, daß
zum einen die mechanischen Toleranzen der Chips berücksichtigt sind, zum andern aber die dadurch bedingte unterschiedliche Winkellage der Chips in der Ausnehmung 4 nicht
größer ist als diejenige Winkellage, die durch die Winkellagen-Korrektureinrichtung an dem Kontaktierautomaten
ausgeglichen werden kann (Fig.4).

Ein Vorteil, der sich mit dem erfindungsgemäßen Verfahren
und der erfindungsgemäßen Vorrichtung gegenüber einer Verarbeitung von ganzen Scheiben erzielen läßt, ist auch,
daß bei großflächigen hochintegrierten und hochpoligen
Schaltkreisen, von den meist nur eine relativ kleine Anzahl von Systemen auf einer Scheibe angeordnet ist und
deren Ausbeute pro Scheibe vergleichsweise niedrig ist,
sich die guten Chips von mehreren Scheiben auf einer gemeinsamen Trägerplatte mit Matrixplatte zusammenfassen
lassen. Dies ist besonders dann der Fall, wenn der Durchmesser der zu verarbeitenden Scheibe kleiner ist als der
mit den Kontaktierautomaten maximal verarbeitbaren Scheiben
durchmesser. Ferner ist vorteilhaft, daß der Kontaktierautomat zwischen der Verarbeitung von ganzen Scheiben und
der Verarbeitung von Einzelchips mit Hilfe der erfindungsgemäßen Vorrichtung nicht umgerüstet werden muß.

12 Patentansprüche
4 Figuren

0103889
82 P 1791 E

## Patentansprüche

1. Verfahren zum Verarbeiten von einzelnen integrierten Schaltkreisen (Einzelchips) zu filmmontierten integrierten Schaltkreisen (Mikropacks), d a d u r c h g e k e n n z e i c h n e t, daß auf einer sehr gut planparallelen Trägerplatte (1) aus schlecht wärmeleitendem Material eine Platte (3) mit matrixförmig angeordneten Ausnehmungen (4) in Größe der Einzelchips (5) befestigt wird, daß die Einzelchips (5) in die Ausnehmungen dieser Platte (3) eingelegt werden und die Gesamtanordnung in einen Kontaktierautomaten eingelegt und dort in an sich bekannter Weise weiterbearbeitet wird.

2. Vorrichtung zur Durchführung des Verfahrens nach Anspruch 1, g e k e n n z e i c h n e t durch eine Trägerplatte (1) hoher Planparallelität aus schlecht wärmeleitendem Material mit einer darauf befestigten Platte (3) mit matrixförmig angeordneten Ausnehmungen (4) zur Aufnahme von zu kontaktierenden Chips (5).

3. Vorrichtung nach Anspruch 2, g e k e n n z e i c h - n e t durch eine Trägerplatte (1) aus Glas.

4. Vorrichtung nach Anspruch 2 oder 3, g e k e n n z e i ch - n e t durch eine Matrixplatte (3) aus nichtlötfähigem bzw. lötunfähig gemachtem Material mit etwa gleichem Ausdehnungskoeffizienten wie die Trägerplatte (1).

5. Vorrichtung nach einer der Ansprüche 2 bis 4, d a d u r ch g e k e n n z e i c h n e t, daß die Matrixplatte (3) mit Hilfe von Epoxidkleber (2) auf die Trägerplatte (1) aufgeklebt ist.

0103889
82 P 1 7 9 1 E

6. Vorrichtung nach einem der Ansprüche 2 bis 4, d a d u r ch g e k e n n z e i c h n e t, daß die Matrixplatte (3) mit Hilfe von Wafer-Wachs (2) auf die Trägerplatte (1) aufgeklebt ist.

7. Vorrichtung nach einem der Ansprüche 2 bis 6, g e - k e n n z e i c h n e t durch eine Matrixplatte (3) aus Kovar.

8. Vorrichtung nach einem der Ansprüche 2 bis 6, g e - k e n n z e i c h n e t durch eine Matrixplatte (3) aus Keramik.

9. Vorrichtung nach einem der Ansprüche 2 bis 8, d a d u r ch g e k e n n z e i c h n e t, daß die Dicke der Matrixplatte (3) einschließlich Kleberschicht (2) kleiner ist als die minimale Dicke der zu kontaktierenden Einzelchips (5).

10. Vorrichtung nach einem der Ansprüche 2 bis 9, d a d u r ch g e k e n n z e i c h n e t, daß der gegenseitige Ab-stand der Ausnehmungen (4) in der Matrixplatte (3) so groß ist, daß eine unbeabsichtigte Kontaktierung benachbarter Chips (5) mit Sicherheit vermieden wird.

11. Vorrichtung nach einem der Ansprüche 2 bis 10, d a d u r ch g e k e n n z e i c h n e t, daß die Ausnehmungen (4) im wesentlichen rechteckförmig sind mit von den Rändern her nach innen ragenden trapezförmigen Ansätzen (7,8, 7,10) zum Anlegen der Chips (5).

12. Vorrichtung nach einem der Ansprüche 2 bis 11, d a - d u r c h g e k e n n z e i c h n e t, daß an jeder Seite der Ausnehmungen (4) zwei trapezförmige Ansätze (9,10) zum Anlegen der Chips (5) vorgesehen sind.

**0103889**

**82 P 1 7 9 1 E**

13. Vorrichtung nach einem der Ansprüche 2 bis 11, d a -
    d u r c h   g e k e n n z e i c h n e t, daß an einer
    Längsseite und  an einer der benachbarten Querseiten
    der Ausnehmungen (4) je ein Ansatz (7,8) und an den
    beiden anderen Seiten der Ausnehmungen (4) je zwei
    Ansätze (9,10) vorgesehen sind.

FIG 1

FIG 2

0103889

3

4

5

FIG 3

9 9 4

10

7

10

5

8

FIG 4

5

α